(19)

Europäisches
Patentamt
European
Patent Office
Office européen
des brevets

(11) **EP 4 459 934 A1**

(12) **EUROPEAN PATENT APPLICATION**

(43) Date of publication:
**06.11.2024 Bulletin 2024/45**

(21) Application number: **24169649.1**

(22) Date of filing: **11.04.2024**

(51) International Patent Classification (IPC):
***H04L 25/02*** (2006.01)          ***H04B 1/04*** (2006.01)
***H03F 1/32*** (2006.01)

(52) Cooperative Patent Classification (CPC):
**H04L 25/0212; H03F 1/3241; H04B 1/0475;**
H04L 25/022

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **28.04.2023  FI 20235475**

(71) Applicant: **Nokia Solutions and Networks Oy
02610 Espoo (FI)**

(72) Inventor: **ALIJAN, Mehdi
Carrollton (US)**

(74) Representative: **Nokia EPO representatives
Nokia Technologies Oy
Karakaari 7
02610 Espoo (FI)**

(54) **WIDEBAND RESPONSE ACQUISITION FROM MULTIPLE NARROWBAND ANALOG OBSERVATIONS**

(57)    Wideband response acquisition from multiple narrowband analog observations is provided. A method for wideband response acquisition from multiple narrowband analog observations may include estimating an impulse response of a transmission path of each of a plurality of frequency subbands in an analog domain and estimating an impulse response of a digital pre-distortion observation path of each of the subbands based on the estimated impulse responses of the transmission path of the frequency subbands. The method may further include modifying at least one frequency subband using an alias component to increase a bandwidth of the at least one frequency subband and reconstructing a wideband impulse response by aggregating the modified at least one frequency subband and the remaining frequency subbands.

EP 4 459 934 A1

**Description**

**TECHNICAL FIELD**

Some example embodiments may generally relate to mobile or wireless telecommunication systems, such as Long Term Evolution (LTE) or fifth generation (5G) new radio (NR) access technology, or 5G beyond, or other communications systems. For example, certain example embodiments may relate to wideband response acquisition from multiple narrowband analog observations.

**BACKGROUND**

Examples of mobile or wireless telecommunication systems may include the Universal Mobile Telecommunications System (UMTS) Terrestrial Radio Access Network (UTRAN), Long Term Evolution (LTE) Evolved UTRAN (E-UTRAN), LTE-Advanced (LTE-A), MulteFire, LTE-A Pro, and/or fifth generation (5G) radio access technology or new radio (NR) access technology. 5G wireless systems may refer to a next generation (NG) of radio systems and network architecture. It is estimated that the 5G (or NR) may provide bitrates on the order of 10-20 Gbit/s or greater and may support at least enhanced mobile broadband (eMBB) and ultra-reliable low-latency communication (URLLC), as well as, massive machine-type communication (mMTC). NR is expected to deliver extreme broadband and ultra-robust, low-latency connectivity and massive networking to support the Internet of Things (IoT).

**SUMMARY**

In accordance with some example embodiments, a method may include estimating an impulse response of a transmission path of each of a plurality of frequency subbands in an analog domain. The method may further include estimating an impulse response of a digital pre-distortion observation path of each of the plurality of subbands based on the estimated impulse responses of the transmission path of the plurality of frequency subbands. The method may further include modifying at least one frequency subband of the plurality of frequency subbands using an alias component to increase a bandwidth of the at least one frequency subband. The method may further include reconstructing a wideband impulse response by aggregating the modified at least one frequency subband and the remaining frequency subbands of the plurality of subbands.

In accordance with certain example embodiments, an apparatus may include means for estimating an impulse response of a transmission path of each of a plurality of frequency subbands in an analog domain. The apparatus may further include means for estimating an impulse response of a digital pre-distortion observation path of each of the plurality of subbands based on the estimated impulse responses of the transmission path of the plurality of frequency subbands. The apparatus may further include means for modifying at least one frequency subband of the plurality of frequency subbands using an alias component to increase a bandwidth of the at least one frequency subband. The apparatus may further include means for reconstructing a wideband impulse response by aggregating the modified at least one frequency subband and the remaining frequency subbands of the plurality of subbands.

In accordance with various example embodiments, a non-transitory computer readable medium may include program instructions that, when executed by an apparatus, cause the apparatus to perform at least a method. The method may include estimating an impulse response of a transmission path of each of a plurality of frequency subbands in an analog domain. The method may further include estimating an impulse response of a digital pre-distortion observation path of each of the plurality of subbands based on the estimated impulse responses of the transmission path of the plurality of frequency subbands. The method may further include modifying at least one frequency subband of the plurality of frequency subbands using an alias component to increase a bandwidth of the at least one frequency subband. The method may further include reconstructing a wideband impulse response by aggregating the modified at least one frequency subband and the remaining frequency subbands of the plurality of subbands.

In accordance with some example embodiments, a computer program product may perform a method. The method may include estimating an impulse response of a transmission path of each of a plurality of frequency subbands in an analog domain. The method may further include estimating an impulse response of a digital pre-distortion observation path of each of the plurality of subbands based on the estimated impulse responses of the transmission path of the plurality of frequency subbands. The method may further include modifying at least one frequency subband of the plurality of frequency subbands using an alias component to increase a bandwidth of the at least one frequency subband. The method may further include reconstructing a wideband impulse response by aggregating the modified at least one frequency subband and the remaining frequency subbands of the plurality of subbands.

In accordance with certain example embodiments, an apparatus may include at least one processor and at least one memory storing instructions that, when executed by the at least one processor, cause the apparatus at least to estimate an impulse response of a transmission path of each of a plurality of frequency subbands in an analog domain.

The at least one memory and instructions, when executed by the at least one processor, may further cause the apparatus at least to estimate an impulse response of a digital pre-distortion observation path of each of the plurality of subbands based on the estimated impulse responses of the transmission path of the plurality of frequency subbands. The at least one memory and instructions, when executed by the at least one processor, may further cause the apparatus at least to modify at least one frequency subband of the plurality of frequency subbands using an alias component to increase a bandwidth of the at least one frequency subband. The at least one memory and instructions, when executed by the at least one processor, may further cause the apparatus at least to reconstruct a wideband impulse response by aggregating the modified at least one frequency subband and the remaining frequency subbands of the plurality of subbands.

In accordance with various example embodiments, an apparatus may include estimating circuitry configured to estimate an impulse response of a transmission path of each of a plurality of frequency subbands in an analog domain. The apparatus may further include estimating circuitry configured to estimate an impulse response of a digital pre-distortion observation path of each of the plurality of subbands based on the estimated impulse responses of the transmission path of the plurality of frequency subbands. The apparatus may further include modifying circuitry configured to modify at least one frequency subband of the plurality of frequency subbands using an alias component to increase a bandwidth of the at least one frequency subband. The apparatus may further include reconstructing circuitry configured to reconstruct a wideband impulse response by aggregating the modified at least one frequency subband and the remaining frequency subbands of the plurality of subbands.

## BRIEF DESCRIPTION OF THE DRAWINGS

For proper understanding of example embodiments, reference should be made to the accompanying drawings, as follows:

FIG. 1A illustrates a block diagram of an example mmWave analog beamforming base station, according to various example embodiments;

FIG. 1B illustrates a block diagram of an example mmWave analog beamforming base station that is a continuation of FIG. 1A, according to various example embodiments;

FIG. 2 illustrates an example block diagram of an estimator in the digital domain, according to some example embodiments;

FIG. 3 illustrates a graphical diagram for an example using an 800 MHz test signal in log scale, according to some example embodiments;

FIG. 4 illustrates a graphical diagram for an example of a resulting spectrum analyzer measurement covering an overall 1600 MHz band, according to some example embodiments;

FIG. 5A illustrates graphical diagram of an inverse impulse response of a first subband, according to various example embodiments;

FIG. 5B illustrates another graphical diagram of the inverse impulse response of a first subband, according to certain example embodiments;

FIG. 6A illustrates a graphical diagram of an inverse impulse response of a second subband, according to various example embodiments;

FIG. 6B illustrates another graphical diagram of an inverse impulse response of a second subband, according to some example embodiments;

FIG. 7A illustrates a graphical diagram of a computed inverse impulse response over the 1600 MHz band, according to various example embodiments;

FIG. 7B illustrates another graphical diagram of a computed inverse impulse response over the 1600 MHz band, according to some example embodiments;

FIG. 8 illustrates a graphical diagram of a resulting overall 1600 MHz equalized response, according to certain example embodiments;

FIG. 9 illustrates an example of mmWave radio response operating within a specified frequency range, according to certain example embodiments;

FIG. 10 illustrates an example of a linear system schematic for a two subband configuration, according to various example embodiments;

FIGS. 11A and 11B illustrate an example flow diagram of one or more procedures/algorithms, according to some example embodiments;

FIG. 12 illustrates an example flow diagram of one or more procedures/algorithms with alias component modification, according to various example embodiments;

FIG. 13 illustrates an example of simulation results for applying one or more procedures/algorithms, according to some example embodiments;

FIG. 14 illustrates another example of simulation results for applying one or more procedures/algorithms, according to various example embodiments;

FIG. 15 illustrates a further example of simulation results for applying one or more procedures/algorithms, according to various example embodiments;

FIG. 16 illustrates another example of simulation results for applying one or more procedures/algorithms, according to certain example embodiments;

FIG. 17 illustrates an example of simulation results for applying one or more procedures/algorithms, according to various example embodiments;

FIG. 18 illustrates a further example of simulation results for applying one or more procedures/algorithms, according to various example embodiments;

FIG. 19 illustrates a further example of simulation results for applying one or more procedures/algorithms, according to certain example embodiments;

FIG. 20 illustrates another example of simulation results for applying one or more procedures/algorithms, according to some example embodiments;

FIG. 21 illustrates an example of simulation results for applying one or more procedures/algorithms, according to certain example embodiments;

FIG. 22 illustrates an example of a source fed to an observation path with a response using an inverse impulse response, according to various example embodiments;

FIG. 23 illustrates an example diagram of a Martian radio with a subband of 800 MHz, according to various example embodiments;

FIG. 24 illustrates an example of a flow diagram of another method, according to certain example embodiments; and

FIG. 25 illustrates a set of apparatuses, according to various example embodiments.


## DETAILED DESCRIPTION

It will be readily understood that the components of certain example embodiments, as generally described and illustrated in the figures herein, may be arranged and designed in a wide variety of different configurations. The following is a detailed description of some example embodiments of systems, methods, apparatuses, and non-transitory computer program products for wideband response acquisition from multiple narrowband analog observations. Although the devices discussed herein and illustrated in the figures refer to 5G or Next Generation NodeB (gNB) devices, this disclosure is not limited to only gNBs. For example, the following description may also apply to any type of network access node.

Additionally, if desired, the different functions or procedures discussed herein may be performed in a different order and/or concurrently with each other. Furthermore, if desired, one or more of the described functions or procedures may be optional or may be combined. As such, the following description should be considered as illustrative of the principles and teachings of certain example embodiments, and not in limitation thereof.

In 5G/NR technology, a millimeter wave (mmWave) frequency band may be used to increase throughput of data in a network. An ultrabroadband modulated signal may be used to enable high-speed transmission using the mmWave frequency band. A power amplifier may be used on wireless communication systems and networks. The power amplifier may have linearity requirements or guidelines imposed for efficient operation of the power amplifier. Measurement systems for dynamic characterization of power amplifiers may have a bandwidth and a dynamic range that limit the possibilities to adequately model the behavior of the power amplifier. A nonlinearity in the power amplifier may hinder performance of the power amplifier by creating distortion in transmitted signals. The distortion may cause frequency leakage, increased interference, and/or degradation in the reception (Rx) performance. When nonlinearity in the power amplifier may cause distortion in the transmitted signals, a transmission power back-off that lowers transmission power efficiency to compensate or mitigate the effects of the distortion. A digital pre-distortion (DPD) may be applied before the power amplifier in a radio frequency (RF) circuit to reduce the impact of the nonlinearity and/or distortion.

In mmWave radio DPD implementation, a DPD observation path may need to be characterized or mapped. For example, the DPD observation path may be characterized over a frequency region with a predefined bandwidth. As just one example, a bandwidth of the DPD observation path may be approximately in the range of 1600 MHz-3200 MHz. In some instances, to characterize the DPD observation path in mmWave radio, a transmission path of the radio system may be used as the source. However, the transmission path of a given radio system may introduce distortions into the signal that may need to be compensated for prior to using the signal of the transmission path for characterization or mapping of the DPD observation path. In an example, an instantaneous bandwidth of a transmission path of a given mmWave radio may be a predefined bandwidth, such as, for example, 800 MHz, 1600 MHz, etc., such that applying a pre-distortion strategy that necessitates a bandwidth greater than the available instantaneous bandwidth, such as a pre-distortion strategy that necessitates a bandwidth of 3200 MHz or more, may be impractical or ineffective.

A transfer function that models or represents a behavior of a given known system may be generated and used to define causal and non-causal portions of a linear system. The end-to-end processing of the transfer function may be performed in the digital domain. Equation (1) below may be an example of a transfer function of an example system as

follows:

$$
\begin{pmatrix} y_0 \\ y_1 \\ y_2 \\ y_3 \\ \vdots \\ y_{n-1} \end{pmatrix} = \begin{pmatrix} H_0 & z^{-1}H_1 & z^{-1}H_2 & \cdots & z^{-1}H_{n-1} \\ H_1 & H_0 & z^{-1}H_1 & \cdots & z^{-1}H_{n-2} \\ \vdots & & \ddots & & \vdots \\ H_{n-3} & & \ddots & & z^{-1}H_2 \\ H_{n-2} & H_{n-3} & \cdots & & z^{-1}H_1 \\ H_{n-1} & H_{n-2} & \cdots & & \ddots H_0 \end{pmatrix} \begin{pmatrix} x_0 \\ x_1 \\ x_2 \\ x_3 \\ \vdots \\ x_{n-1} \end{pmatrix}, \qquad (1)
$$

where a vector x comprising $[x_0, x_1, x_2, ..., x_{n-1}]$ defines a plurality of samples of an input signal of the system, a vector y comprising $[y_0, y_1, y_2, ..., y_{n-1}]$ defines a plurality of samples of an output signal of the system, an *NxN* matrix *H* defines a plurality of the system transfer function components $[H_0, H_1,$ and so on$]$ , and $z^{-1}$ defines a single time sample delay applied to the input signal samples x $[x_0, x_1, x_2, ..., x_{n-1}]$. According to Equation (1), an output sample $y_0$ results from multiplying a first row of transfer function matrix $[H_0, z^{-1}H_1, z^{-1}H_2, ..., z^{-1}H_{n-1}]$ by a first set of input signal samples x $[x_0, x_1, x_2, ..., x_{n-1}]$ captured within a first predefined period of time.

Example equalization methods may include collecting discrete frequency points in the transmission band and/or magnitude data only, which lacks phase data usable for group delay correction. Accordingly, these equalization methods may result in correction and equalization that may be insufficient for operating 5G mmWave radio and/or 6G radio products.

Various example embodiments may provide advantages to resolve issues known in the technology, such as the issues discussed above. For example, certain example embodiments may advantageously provide one or more procedures for characterization of the DPD observation path. Certain example embodiments may provide for large bandwidth (e.g., a bandwidth $\geq$ 3200 MHz) characterization/equalization of transmission and DPD observation path for proper operation of mmWave radio in 5G and 6G enabler networks and systems.

In mmWave radio, a digital pre-distortion may correct or compensate for in-band nonlinearity and error vector magnitude (EVM). For example, various example embodiments may provide pre-distortion to correct out-of-band 3rd order intermodulation (IM3) products, which may enable meeting an out-of-band (OOB) emission limits provided by Earth exploration satellite services (EESS) requirements for the 24 GHz band. An example desired bandwidth of the DPD observation path may be selected as to be one of approximately equal to the bandwidth of the transmission path, approximately twice (e.g., two times) the bandwidth of the transmission path, or thrice (e.g., three times) the bandwidth of the transmission path. Of course, other values of the bandwidth of the DPD observation path, whether considered independently or with respect to the bandwidth of the transmission path, are also contemplated.

Various example embodiments may include one or more procedures or algorithms configured to divide an analog bandwidth into a plurality of subbands, such as, for example, dividing 3200 MHz or 4800 MHz analog bandwidth into 800 MHz or 1600 MHz subbands. A corresponding impulse response for each subband may be estimated and a larger aggregate bandwidth may be reconstructed from the impulse responses of the respective subbands. The resulting impulse response may be used to generate an inverse impulse response of the wideband observation path. The generated one or more inverse impulse responses may be stored in a look-up table to be loaded into respective finite impulse response (FIR) filters.

Certain example embodiments may provide one or more procedures or algorithms to reconstruct an impulse response for a wideband observation path based on multiple narrowband characterizations performed in an analog domain, i.e., upon capturing the RF signal in its continuous form and prior to the RF signal being digitized and/or discretized via processing using one or more digital components. One or more wideband impulse responses may be provided from one or more narrowband responses using alias component analysis and synthesis processing in a digital domain, i.e., upon, or in response to, digitization and/or discretization of the RF signal via processing of the RF signal using one or more digital components. Various example embodiments may provide one or more procedures or algorithms for large (e.g., > 3200 MHz) bandwidth equalization for both transmission path and DPD observation path, which may be implemented in various communication networks, such as sub-6 GHz radios, mmWave-5G, and/or 6G products.

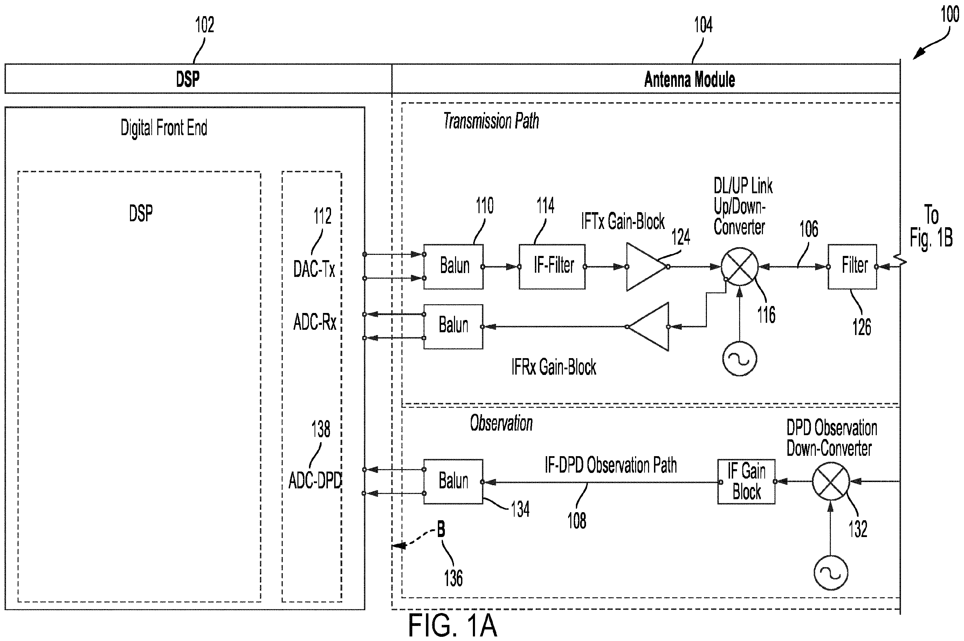

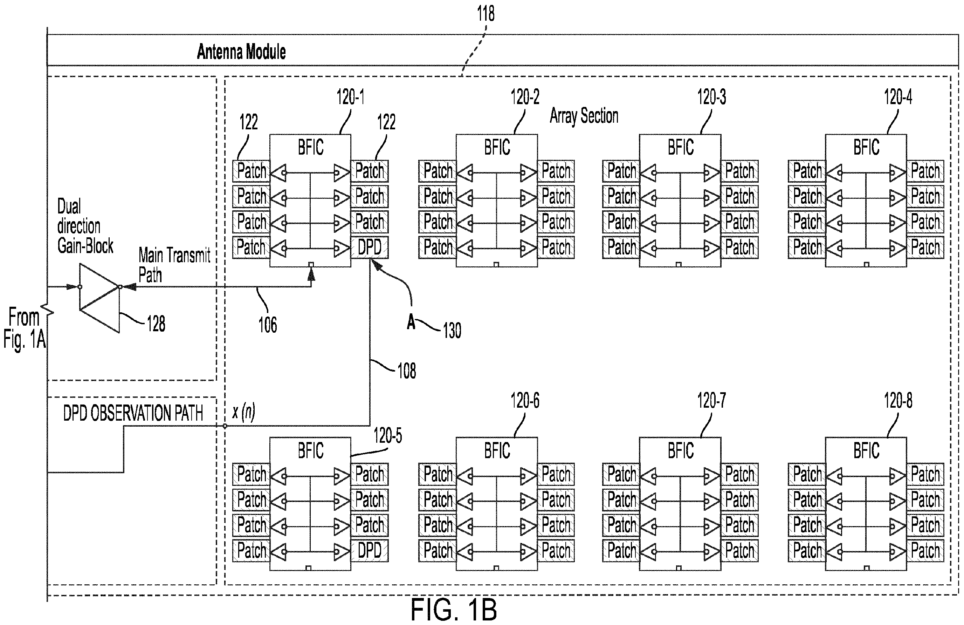

FIGS. 1A and 1B illustrate a block diagram of an example mmWave analog beamforming base station 100, according to various example embodiments. The base station 100 includes a digital signal processor (DSP) module 102 and an antenna module 104. The example block diagram illustrates a transmission path 106 and an observation path 108. While the base station 100 as illustrated in FIGS. 1A and 1B includes one transmission path and one observation path, certain example embodiments are not limited to the one transmission path and observation path as illustrated in FIGS. 1A and 1B. Various additional or alternative transmission paths and observation paths, including transmission paths and observation paths with same or different starting and ending points, may be provided according to certain example embodiments. The DSP module 102 may include a digital front end.

As illustrated in FIG. 1A, the transmission path 106 may begin at an output of a transmission digital-to-analog converter (DAC-Tx) 112. The transmission path 106 may include a balun 110 and to an intermediate frequency (IF) filter 114. The transmission path 106 may, in some instances, be analog. In an example, the IF filter 114 may be configured to filter the output signal of the DAC-Tx 112 and output the filtered signal to a downlink (DL)/uplink (UL) up-down converter 116; the signal in the transmission path 106 may then be directed to an analog array 118 illustrated in FIG. 1B.

As illustrated in FIG. 1B, the analog array 118 may include an array of integrated circuit power amplifiers 120, such as, for example, an array of beamforming RF integrated circuit power amplifiers (BFIC-PAs). As illustrated in FIG. 1, the analog array 118 may include a plurality of-power amplifiers 120, where each power amplifier 120-1, 120-2, 120-3, ...120-n includes a plurality of patches 122. Of course, the transmission path 106 may include additional circuitry elements or structures, such as, for example, an intermediate frequency (IF) transmitter (IFTX) gain block 124, one or more additional filters 126, a dual direction gain block 128, and the like.

A signal output by the power amplifiers 120 of the array 118 along the observation path 108 may be used for DPD observation (hereinafter, the DPD observation path 108). In an example, the DPD observation path 108 may begin at point A 130 at an output of the power amplifier 120. In this manner, the DPD observation path 108 may extend from the power amplifier 120 toward and through a DPD observation down converter 132, an IF gain block, a balun 134, and/or toward a DPD analog-to-digital converter (ADC-DPD) 138. Accordingly, the signal output by the power amplifier 120 may proceed along the observation path 108 and may end at a point B 136, e.g., at an input to the ADC-DPD 138, as illustrated in FIG. 1A.

In some instances, the one or more signals transmitted through the DPD observation path 108 may be monitored and/or controlled by a processor, or another hardware element, configured to execute, for example, a radio frequency control software (RFSW). The signal transmitted along the transmission path 106 may remain in analog form when it enters the power amplifier 120. Further, the signal output by the power amplifier 120 and transferred along the DPD observation path 108 may be in analog form, i.e., continuous and/or not discrete. The ADC-DPD 138 may be configured to convert the signal transmitted along the DPD observation path 108 into a digital form, e.g., by digitizing the signal.

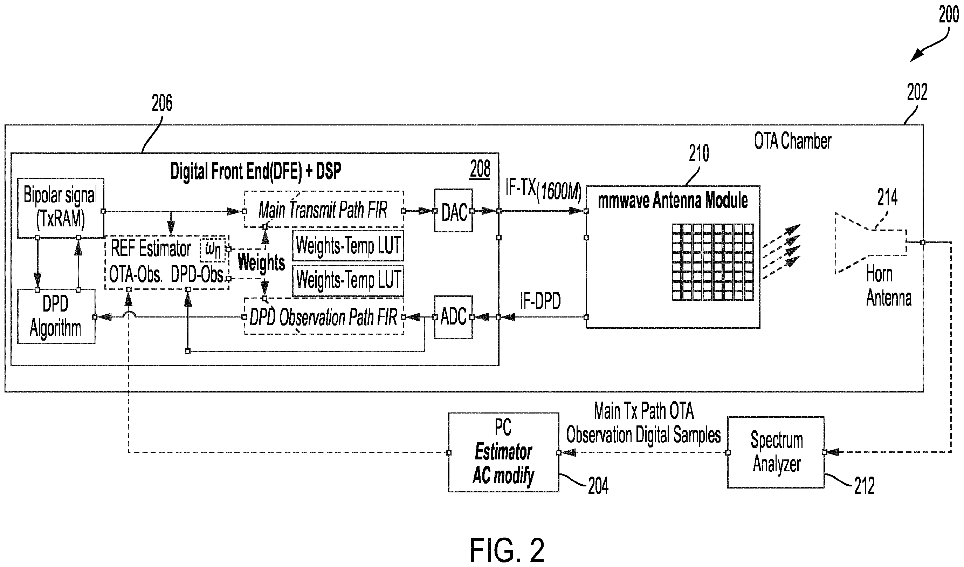

The DSP module 102 of the base station 100 may transmit a test signal (e.g., a test signal developed as described at least in reference to FIG. 2) to the antenna module 104 via the transmission path 106. The base station 100 may determine an impulse response of an inverse of the transmission path 106. The base station 100 may determine an impulse response of the DPD observation path 108.

A signal may be transmitted from the DAC-Tx 112 and looped back to be received at the ADC-DPD 138. The corresponding impulse responses of each of the transmission path 106 and the DPD observation path 108 may be superimposed onto each other and may be decomposed from one another. The decomposition process may be performed for the signal transmitted along the transmission path 106 using a previously obtained over the air (OTA) measurement (see, e.g., FIG. 2). A signal may be transmitted along the transmission path 106 by transmitting the signal from the DAC-Tx 112, which is received by an OTA horn antenna for a spectrum analyzer. The signal may be processed by a processor, such as a personal computer (PC), application-specific integrated circuit (ASIC), and the like, to estimate a frequency response of the transmission path 106. The inverse impulse response of the signal may be applied to the transmission path 106 to flatten the impulse response of the transmission path 106.

The system of the present disclosure may be configured to perform a decomposition process for the loop back of the transmission path 106 to the DPD observation path 108 using OTA measurement. In response to impulse response of the transmission path 106 being flat, data from the transmission path 106 in series with the DPD observation path 108 may be received at the ADC-DPD 138. This data represents the impulse response of the DPD observation path 108 and the response of the two paths may be decomposed. The system may be configured to store data associated with an inverse of the impulse response of the signal transmitted along the DPD observation path 108.

FIG. 2 illustrates an example test configuration block diagram 200 including an OTA chamber 202, according to various example embodiments. The OTA chamber 202 includes an estimator 204, according to various example embodiments. The example estimator 204 may be configured to implement one or more algorithms that may be processed or executed by, for example, a PC, processor, internal ASIC, and the like. The OTA chamber 202 includes a digital front end 206 and a DSP 208 configured to transmit and receive one or more signals to a mmWave antenna module 210 of the OTA chamber 202. A spectrum analyzer 212 may receive an output from the mmWave antenna module 210 via a horn antenna 214. The spectrum analyzer 212 may be configured to output one or more test signals to be transferred along the transmission path toward the estimator 204 of a processing device, such as a processor, PC, etc.

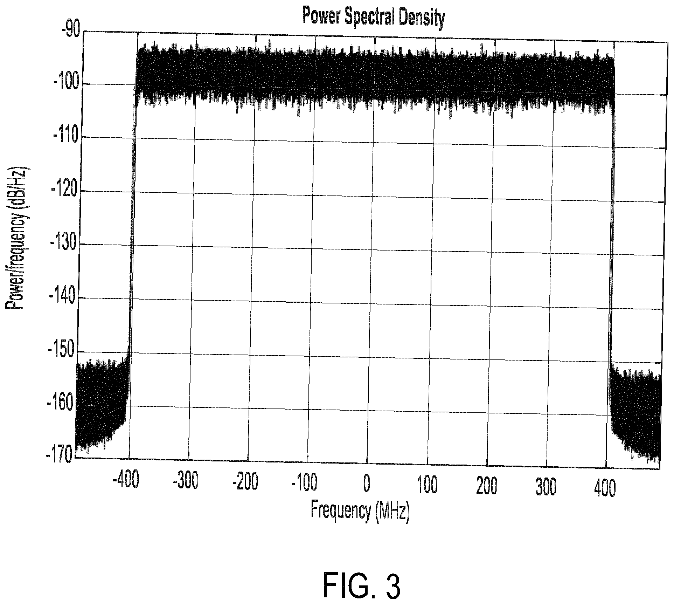

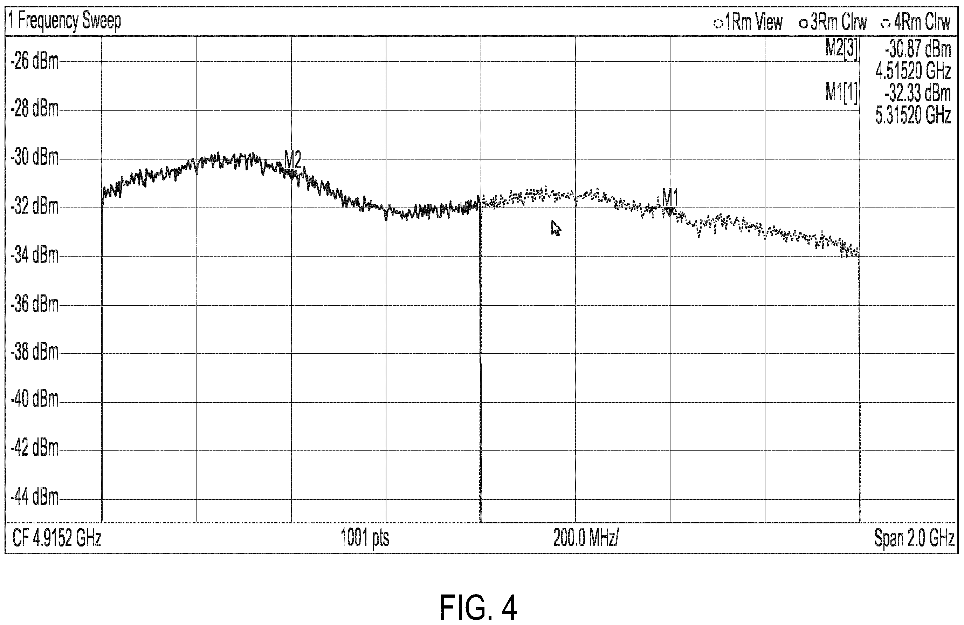

As an example of processing a 5G mmWave using, for example, the test configuration of FIG. 2, an 800-MHz-wide waveform may be generated and transmitted through a transmission path. Next, an OTA measurement may be performed by a horn antenna-spectrum analyzer, such as the spectrum analyzer 212 shown in FIG. 2, which may capture complex magnitude and phase (I/Q) output data. FIG. 3 illustrates a graphical diagram for this example using the 800 MHz test signal in log scale, according to certain example embodiments. Two measurements may be performed in which a first measurement is performed for a first subband over 800 MHz, and a second measurement is performed for a second subband 800-MHz-wide positioned in the next 800 MHz region. FIG. 4 illustrates a graphical diagram of a resulting spectrum analyzer measurement for a 1600-MHz-wide band, according to some example embodiments.

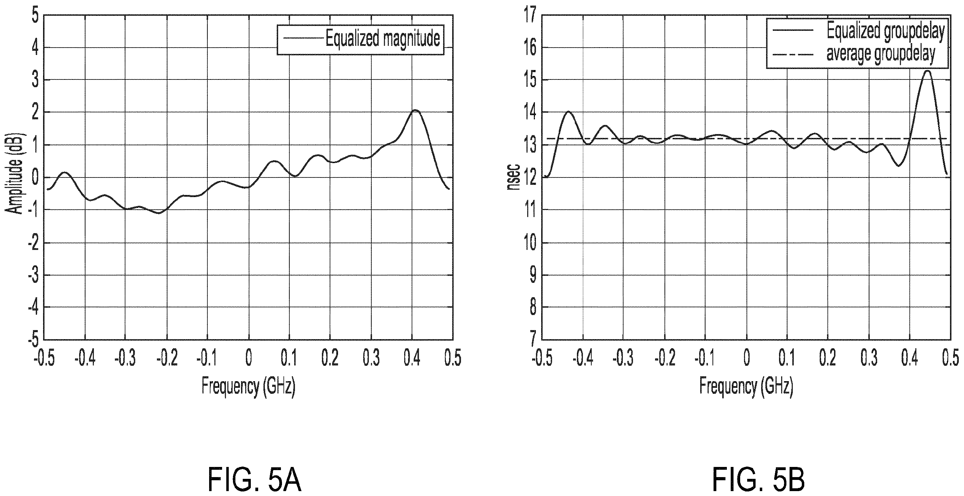

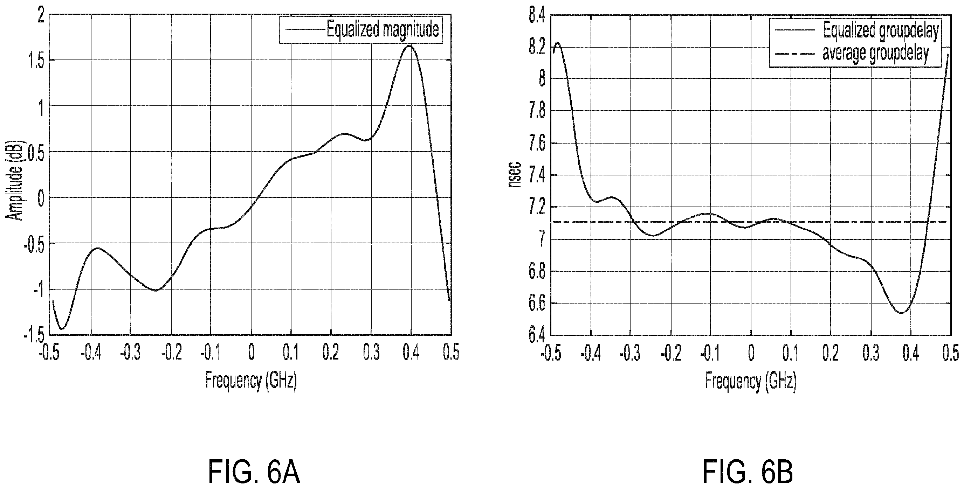

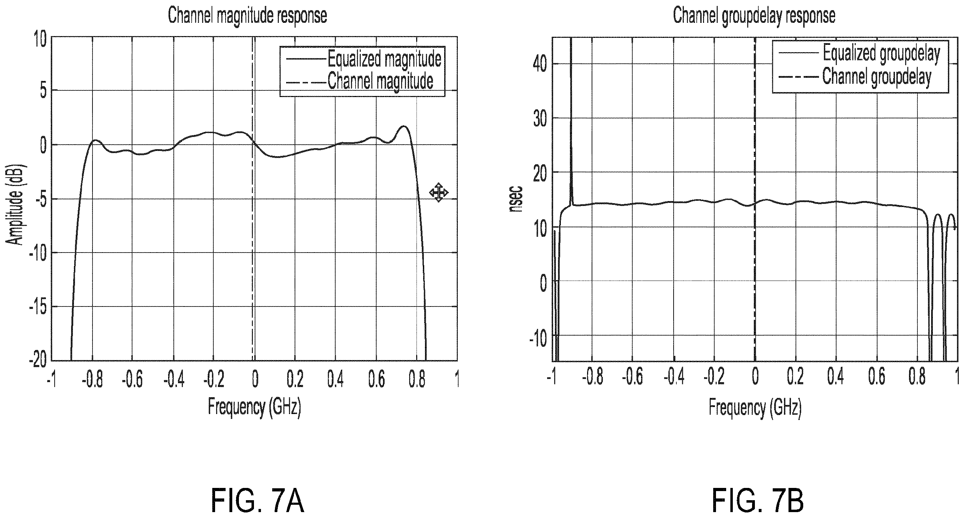

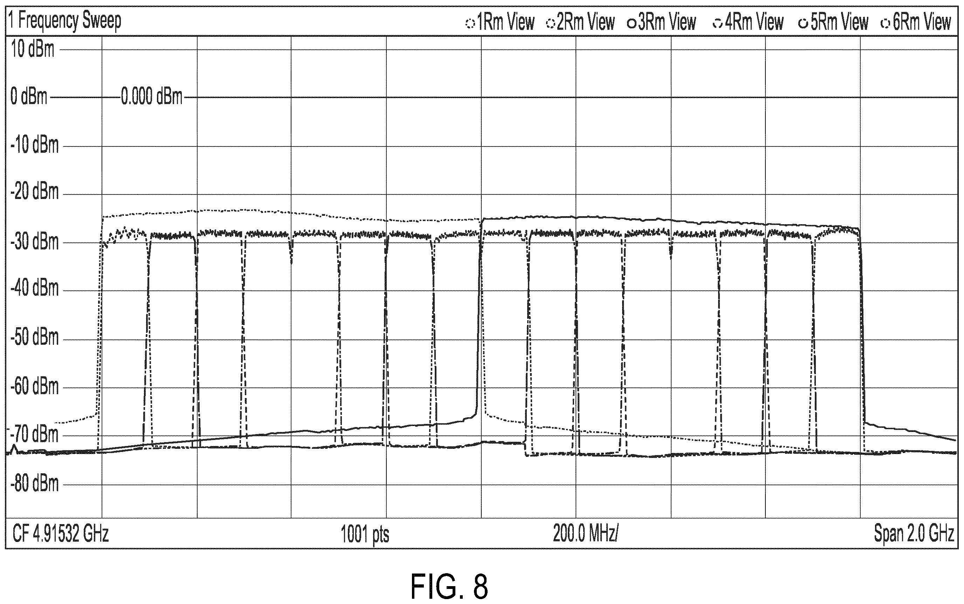

As illustrated in FIG. 4, the first subband has approximately a 2.5 dB gain ripple, and the second subband has about 2.5 dB ripple. The overall magnitude of the 5G mmWave base station, according to this example, over the 1600 MHz band may be an approximately 4-dB gain ripple. FIGS. 5A and 5B illustrate graphical diagrams of the inverse impulse response of the first subband, according to various example embodiments. FIGS. 6A and 6B illustrate graphical diagrams of an inverse impulse response of the second subband, according to various example embodiments. An overall inverse impulse response over the 1600 MHz band may be computed, including a magnitude and group delay. FIGS. 7A and 7B illustrate graphical diagrams of the computed inverse impulse response over the 1600-MHz band, according to certain example embodiments. FIG. 8 illustrates a graphical diagram of the resulting overall 1600 MHz equalized response, according to some example embodiments, which is determined by transmitting actual 5G NR 100 MHz carriers over the 1600 MHz band, which is a nearly flat response over the 1600 MHz band, as shown in FIG. 8.

Various example embodiments may provide one or more procedures implementing an algorithm that uses multiple analog subbands as one or more inputs, with certain bandwidth, and estimates the corresponding impulse response for each subband with certain number of weights. Using multirate processing and certain alias component synthesis and modification methods, an impulse response may be generated which represents an equivalent sum of all subbands in the analog domain.

An example scenario may include two analog subbands of 1600 MHz each. Using an estimator implemented by a processor, such as a PC or ASIC, the corresponding impulse response of each subband with a bandwidth of 1600 MHz is obtained. Using an alias component synthesis algorithm as described therein, an equivalent impulse response may be generated that may represent a system with twice the bandwidth of analog subbands, such as a bandwidth of 3200 MHz in the digital domain. However, certain example embodiments are not limited to this example scenario. Instead, it may be understood that there may be no limit to the number of subbands. In a wider bandwidth observation, the DPD observation path 108 characterization since there are cases where the transmission bandwidth is 1600 MHz and the observation bandwidth may be at least 2xTx or 3xTx bandwidth. For example, to meet EESS requirements at 24-GHz band, the IM3 may be corrected using pre-distortion, which may necessitate the bandwidth of the DPD observation path 108 to be approximately 3200 MHz.

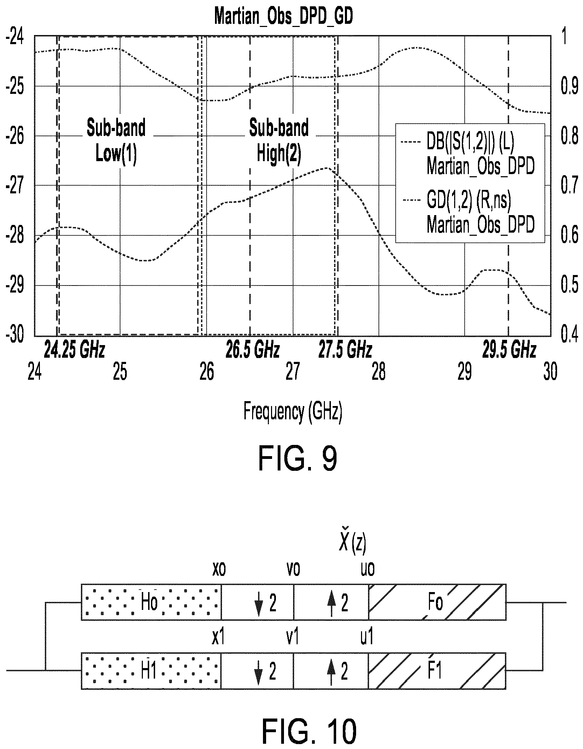

FIG. 9 illustrates an example graph illustrating an impulse response of an example mmWave radio operating within a specified frequency range, according to various example embodiments. For example, an operating band may extend between 24 GHz and 29.5 GHz. As illustrated in the results of FIG. 4, a first portion of the operating band may extend between, and including, frequencies 24 GHz and 27.5 GHz and may be divided into two subbands. For example, a first subband of the first portion may extend between and including 24.25 GHz and 25.85 GHz and a second subband of the first portion may extend between, and including, 25.85 GHz and 27.45 GHz. Each subband may occupy 1600 MHz, which may be due to the transmission path bandwidth that may be limited by an IF filter bandwidth for an instantaneous bandwidth (IBW) of 1600 MHz. Some example embodiments may provide an optimum DPD operation to correct IM3 products, rather than characterizing the DPD observation path 108 using bandwidth equal to the bandwidth of the transmission bandwidth 106.

For the analysis of two subbands and for synthesis of an equivalent aggregate impulse response, certain example embodiments may include analyzing a relationship between an output signal of radio transmission path and respective inputs of each of the first subband and the second subband. In an example, the analysis may include generating the transfer function $H$ of each of the first subband $H_0$ and the second subband $H_1$. This is exemplified by Equation (2) as follows:

$$\begin{pmatrix} y_{0(z)} \\ y_{1(z)} \end{pmatrix} = \begin{pmatrix} H_0 & z^{-1}H_1 \\ H_1 & H_0 \end{pmatrix} \begin{pmatrix} x_{0(z)} \\ x_{1(z)} \end{pmatrix}, \tag{2}$$

where the x vector $[x_0, x_1]$ represents the input vector in $z$ domain and the $y$ vector $[y_0, y_1]$ represents the output vector of the system in $z$ domain. The matrix $H$ comprising $[H_0, H_1]$ denotes the system transfer function in $z$ domain, and $z^{-1}$ corresponds to a ($e^{-i\omega}$) phase shift, e.g., a phase of the input vector $[x_{0(z)}, x_{1(z)}]$ is changed by an amount $\omega = 2 * \pi * f$.

Certain example embodiments of the present disclosure may provide one or more procedures for characterizing subbands in analog domain and reconstructing one or more aggregate wideband impulse responses in the digital domain. Various example embodiments may define one or more devices, systems, and/or methods that include an analysis stage processed in the analog domain and a synthesis stage processed in the digital domain.

The analysis stage may be performed in the analog domain and represents the analog bandwidth of the observation path. Since the analysis stage occurs in the analog domain, some information at the corresponding edges (*e.g.*, ~1% of band) of each of the first and second subbands may not be accessible, which may be needed for a complete reconstruction of an impulse response of the aggregate band. To avoid the information being inaccessible, alias component processing may be performed.

FIG. 10 illustrates an example of a linear system schematic for a two subband configuration, according to various example embodiments. The two-stage procedure/algorithm applied to the two subband configuration of FIG. 10 may be defined by Equations (3)-(5) below. Equation (3) may be an expression for each of the two subbands (0 and 1) that defines the analysis stage as follows:

$$V_0\left(e^{j\omega}\right) = \frac{1}{2}\left(X_0\left(e^{j\frac{\omega}{2}}\right) + X_0\left(e^{j\left(\frac{\omega-\pi}{2}\right)}\right)\right) \qquad V_1\left(e^{j\omega}\right) =$$

$$\frac{1}{2}\left(X_1\left(e^{j\frac{\omega}{2}}\right) + X_1\left(e^{j\left(\frac{\omega-\pi}{2}\right)}\right)\right) \qquad\qquad (3)$$

Equation (4) may be an expression for each of the two subbands (0 and 1) that defines the synthesis stage as follows:

$$U_0\left(e^{j\omega}\right) = v_0\left(e^{j2.\omega}\right) = \frac{1}{2}\left(X_0\left(e^{j\omega}\right) + X_0\left(e^{j(\omega-\pi)}\right)\right)$$

$$U_1\left(e^{j\omega}\right) = v_1\left(e^{j2.\omega}\right) = \frac{1}{2}\left(X_1\left(e^{j\omega}\right) + X_1\left(e^{j(\omega-\pi)}\right)\right) \qquad (4)$$

The analysis stage and the synthesis stage may be combined to achieve an overall system expression defined by Equation (5) as follows:

$$\check{X}(z) = F_0 U_0 + F_1 U_1 \qquad\qquad (5)$$

The overall system expression of Equation (5) may be solved for by substituting Equations (2)-(4) into Equation (5). Equation (6) may be the resulting expression when solving Equation (5) and incorporating an alias component, which may be represented as follows:

$$\check{X}(z) = \left(X\left(e^{j\omega}\right) + X\left(e^{j(\omega-\pi)}\right)\right)\begin{bmatrix} H_0\left(e^{j\omega}\right) & H_1\left(e^{j\omega}\right) \\ H_0\left(e^{j(\omega-\pi)}\right) & H_0\left(e^{j(\omega-\pi)}\right) \end{bmatrix}\begin{pmatrix} F_0\left(e^{j\omega}\right) \\ F_1\left(e^{j\omega}\right) \end{pmatrix}$$

$$\check{X}(z) = \left[H_0\left(e^{j\omega}\right).F_0\left(e^{j\omega}\right) + H_1\left(e^{j\omega}\right).F_1\left(e^{j\omega}\right)\right].X\left(e^{j\omega}\right) + \cdots$$

$$\cdots \left[H_0\left(e^{j(\omega-\pi)}\right).F_0\left(e^{j\omega}\right) + H_1\left(e^{j(\omega-\pi)}\right).F_1\left(e^{j\omega}\right)\right].X\left(e^{j(\omega-\pi)}\right) \quad (6)$$

The alias component of Equation (6) may be $[H_0(e^{j(\omega-\pi)}).F_0(e^{j\omega}) + H_1(e^{j(\omega-\pi)}).F_1(e^{j\omega})].X(e^{j(\omega-\pi)})$. Reconstruction of the aggregate impulse response may be achieved with a bandwidth equal to the sum the bandwidth for the two subbands.

In some example embodiments, each subband in the analog domain may be characterized with a limited accuracy at the one or more edges of the subbands. To improve the accuracy at the edges of the subbands, an example modification algorithm may be implemented as provided herein.

In various example embodiments, a set of expressions for the example modification algorithm may compensate for reduced accuracy at the frequency edges. The series of expressions represent the DPD observation path 108 near the frequency edges. The set of expressions may include the following Equations (7)-(13):

$$F_0(z) = H_1(-z)$$
$$F_1(z) = -H_0(-z) \qquad\qquad (7)$$

$$H_0(z) = H_{00}(z^2) + z^{-1} H_{01}(z^2)$$
$$H_1(z) = H_{10}(z^2) + z^{-1}H_{11}(z^2) \tag{8}$$

$$F_0(z) = F_{00}(z^2) + z^{-1} F_{01}(z^2)$$
$$F_1(z) = F_{10}(z^2) + z^{-1} F_{11}(z^2) \tag{9}$$

$$\widetilde{X_0}(z) = \widetilde{X_{00}(z^2)} + z^{-1}\widetilde{X_{10}(z^2)}$$
$$\widetilde{X_1}(z) = \widetilde{X_{01}(z^2)} + z^{-1}\widetilde{X_{11}(z^2)} \tag{10}$$

$$\begin{pmatrix} \widetilde{X_0} \\ \widetilde{X_1} \end{pmatrix} = \begin{pmatrix} F_{00} & F_{01} \\ F_{10} & F_{11} \end{pmatrix} \begin{pmatrix} H_{00} & z^{-1}H_{01} \\ H_{10} & H_{11} \end{pmatrix} \begin{pmatrix} x_0 \\ x_1 \end{pmatrix}$$
$$\begin{pmatrix} \widetilde{X_{00}} \\ \widetilde{X_{01}} \end{pmatrix} = \begin{pmatrix} F_{00} & \emptyset \\ F_{10} & \emptyset \end{pmatrix} \begin{pmatrix} H_{00} & z^{-1}H_{01} \\ \emptyset & \emptyset \end{pmatrix} \begin{pmatrix} x_0 \\ x_1 \end{pmatrix}$$
$$\begin{pmatrix} \widetilde{X_{10}} \\ \widetilde{X_{11}} \end{pmatrix} = \begin{pmatrix} \emptyset & F_{01} \\ \emptyset & F_{11} \end{pmatrix} \begin{pmatrix} \emptyset & \emptyset \\ H_{10} & H_{11} \end{pmatrix} \begin{pmatrix} x_0 \\ x_1 \end{pmatrix} \tag{11}$$

$$\widetilde{X_1} = \widetilde{X_{01}} + \widetilde{X_{11}} \tag{12}$$

$$H_0 = H_{00} + z^{-1} H_{01} + z^{-2} H_{02} + z^{-3} H_{03} + z^{-4} H_{04} + z^{-5} H_{05} + z^{-6} H_{06} + \ldots$$

$$H_{00}(z^2) = H_{00} + z^{-2} H_{02} + z^{-4} H_{04} + z^{-6} H_{06} \ldots$$

$$H_{01}(z^2) = z^{-1} H_{01} + z^{-3} H_{03} + z^{-5} H_{05} + \cdots = z^{-1} (H_{01} + z^{-2} H_{03} + z^{-4} H_{05} + \cdots) \tag{13}$$

A parameter $W$ may be applied to modify the alias component, which may be defined as $W^{\frac{-j2\pi k f_o}{F_s}}$, where $k$ is a predefined number of impulse response coefficients of the aggregate system, $F_s$ is a resulting sampling frequency used to determine the aggregate bandwidth, $f_o$ defines information at band edges obtained during an analog processing of this system, and $\frac{2\pi k f_o}{F_s}$ defines the vector of complex (e.g., weighted) modifiers on each of the coefficients of the impulse response. The complex modifier vector $W^{\frac{-j2\pi k f_o}{F_s}}$ may modify the respective pole-zero configuration of each of the first subband and the second subband in z domain, such that the phase and magnitude relationship between these two subbands in frequency domain more accurately represents the overall band.

The alias component of the modification algorithm may be defined as follows in Equation (14):

$$h_{ac}(k) = h_{ac}(0), h_{ac}(1), h_{ac}(2), \ldots, h_{ac}(k)$$
$$h_{ac\_mod}(k) = h_{ac} \cdot \sum_{k=0}^{k-1} W^k \tag{14}$$

The $h_{ac}(k)$ vector comprising of [$h_{ac}(0)$, $h_{ac}(1)$,..., $h_{ac}(k)$] denotes the aggregate system impulse response in time domain. $H_{ac-mod}(k)$ represents the modified aggregate system impulse response in time domain which is the result of multiplying the vector $W$ to the initial impulse response $h_{ac}(k)$.

An alias component impulse response modification based on Equation (14) may be defined in Equation (15) as follows:

$$h_{ac\_mod}(k) = [h_{ac}(0), h_{ac}(1), h_{ac}(2), ..., h_{ac}(k-1)].\begin{bmatrix} W^0 \\ W^1 \\ W^2 \\ \vdots \\ W^{k-1} \end{bmatrix} \quad (15)$$

According to certain example embodiments, the modification of the alias component may allow the aggregate impulse response to properly represent the aggregate band, which includes, for example, two subbands Low#1 plus Low#1 shown in FIG. 9.

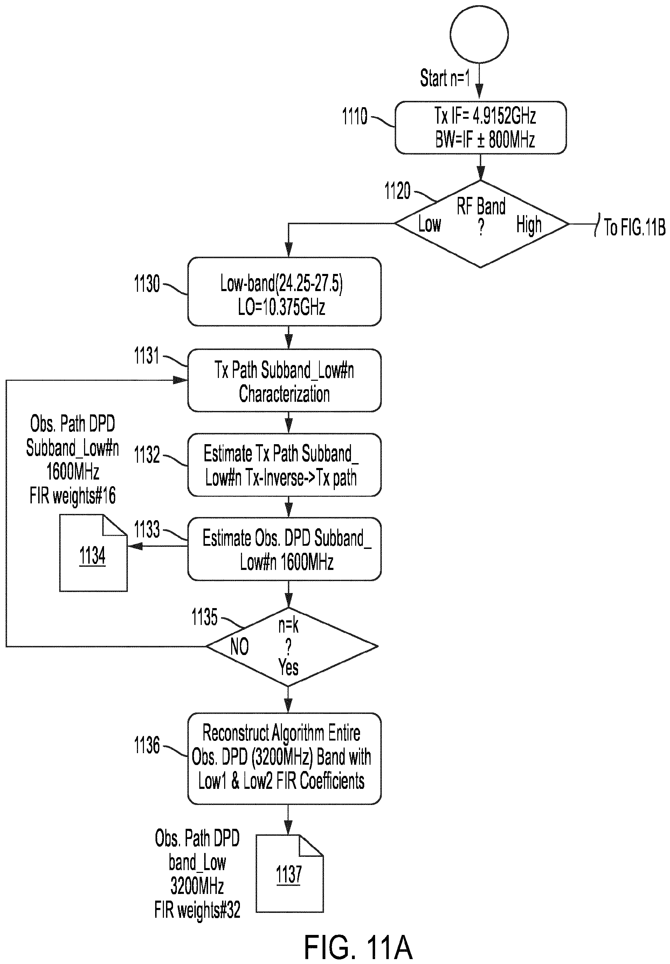

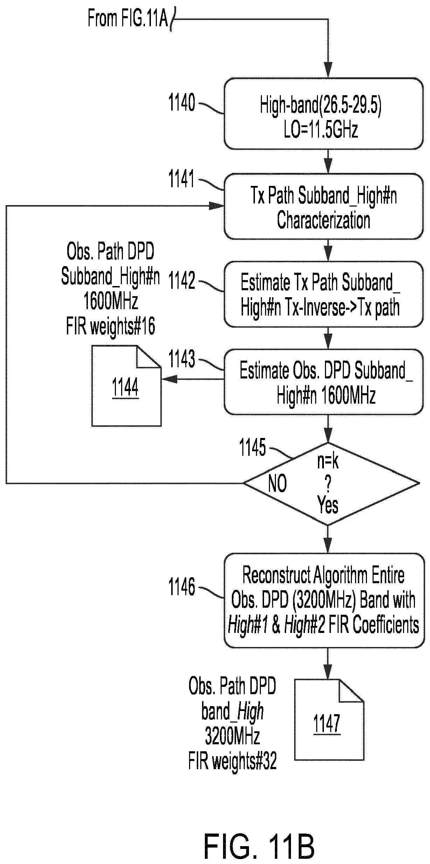

FIGS. 11A and 11B illustrate an example flow diagram of one or more procedures/algorithms, according to various example embodiments. At 1110, a test signal may be applied in an IF range at an antenna module or from a DAC. As an example, the transmission IF may be 4.9152 GHz and the bandwidth may be the IF plus 800 MHz. At 1120, the RF band may be determined to be either "high" or "low" band based on the frequency. For example, the low band may be defined as approximately 3.25 GHz or less.

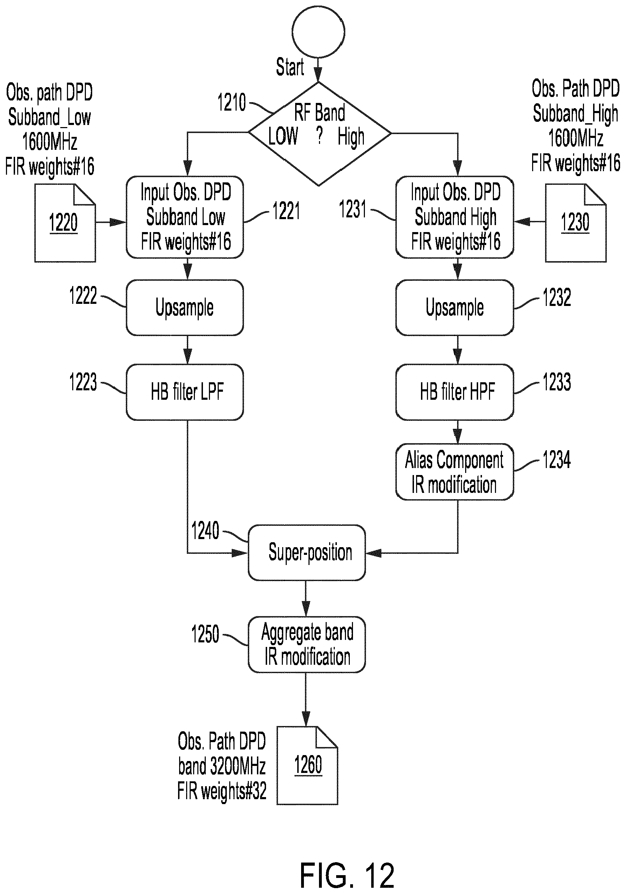

At 1130-1137, the RF band has been determined to be a low band. At 1130, the low band may be 24.25-27.5 GHz with a local oscillator (LO) of 10.375 GHz. Two subbands to be characterized may be 1600 MHz each for the DPD observation path 108. At 1131, the transmission path of the low subband in the OTA may be received. At 1132, the transmission path for the low subband may be estimated and an inverse impulse response may be applied to flatten the transmission path response. At 1133, a DPD observation path 108 may be estimated for the low subband at 1600MHz by estimating the impulse response for the subband based on the combined and flattened waveform, and at 1134, the estimated impulse response for the DPD observation path and corresponding FIR weights/coefficients may be stored. At 1135, it may be determined whether all of the subbands have been processed and the corresponding impulse responses stored. If not, return to 1131, and if yes, proceed to 1136. At 1136, once all impulse responses have been obtained, a complete reconstruction of the impulse responses for the aggregate band may be determined, as discussed in more detail below with respect to FIG. 12. The impulse responses may be reconstructed for the entire DPD observation band by combining the low subbands and FIR weights/coefficients, and at 1137, the reconstructed impulse responses for the DPD observation path 108 may be stored along with the corresponding FIR weights/coefficients.

At 1140-1147, the RF band has been determined to be a high band. At 1140, the high band may be 26.5-29.5 GHz with a local oscillator of 11.5 GHz. Two subbands 1/2 to be characterized may be 1600 MHz each for the DPD observation path 108. At 1141, the transmission path of the low subband in the OTA may be received. At 25142, the transmission path for the low subband may be estimated and an inverse impulse response may be applied to flatten the transmission path response. At 1143, a DPD observation path 108 may be estimated for the low subband at 1600 MHz by estimating the impulse response for the subband based on the combined and flattened waveform, and at 1144, the estimated impulse response for the DPD observation path 108 may be stored. At 1145, it may be determined whether all of the subbands have been processed and the corresponding impulse responses stored. If not, return to 1141, and if yes, proceed to 1146. At 1146, once all impulse responses have been obtained, a complete reconstruction of the impulse responses for the aggregate band may be determined, as discussed in more detail below with respect to FIG. 12. The impulse responses may be reconstructed for the entire DPD observation band by combining the high subbands and FIR weights/coefficients, and at 1147, the reconstructed impulse responses for the DPD observation path may be stored along with the corresponding FIR weights/coefficients.

FIG. 12 illustrates an example flow diagram of one or more procedures/algorithms with alias component modification, according to various example embodiments. At 1210, a test signal may be applied in an IF range at an antenna module or from a DAC and the RF band may be determined to be either "high" or "low" band based on the frequency. For the "high" subband of the RF signal, the flow proceeds to 1230-1234, and for the "low" subband of the RF signal, the flow proceeds to 1220-1223.

At 1220, an observation path DPD subband_Low FIR weights/coefficients may be stored to be used as an input for processing the low subband signal, and at 1221, the observation path DPD subband_Low FIR weights/coefficients may be applied to the observation path DPD subband_Low. At 1222, the low subband signal may be upsampled, and at 1223, the high subband signal may be filtered using a low pass filter, e.g., a half-band low pass filter.

At 1230, an observation path DPD subband_High FIR weights/coefficients may be stored to be used as an input for processing the high subband signal, and at 1231, the observation path DPD subband_High FIR weights/coefficients may be applied to the observation path DPD subband_High. At 1232, the high subband signal may be upsampled, and at 1233, the high subband signal may be filtered using a high pass filter, e.g., a half-band high pass filter. At 1234, the filtered signal may have an alias component modification.

At 1240, the high subband and low subband may be combined and superimposed, and at 1250, an aggregate signal may be constructed from the superimposed high subband and low subband. At 1260, an observation path DPD band FIR weight/coefficient for the aggregate signal may be stored.

Some example embodiments may provide an OTA method that may be performed in factory, during manufacturing, such that there may be a single time OTA calibration performed to characterize and compensate for the transmission path, characterize the DPD observation path 108, and store corresponding impulse responses and weights/coefficients.

Certain example embodiments described herein may use an example with subband=1600 MHz and aggregate=3200 MHz. This is for example purposes only. Certain example embodiments may not be limited to this example and are not limited to any specific bandwidth.

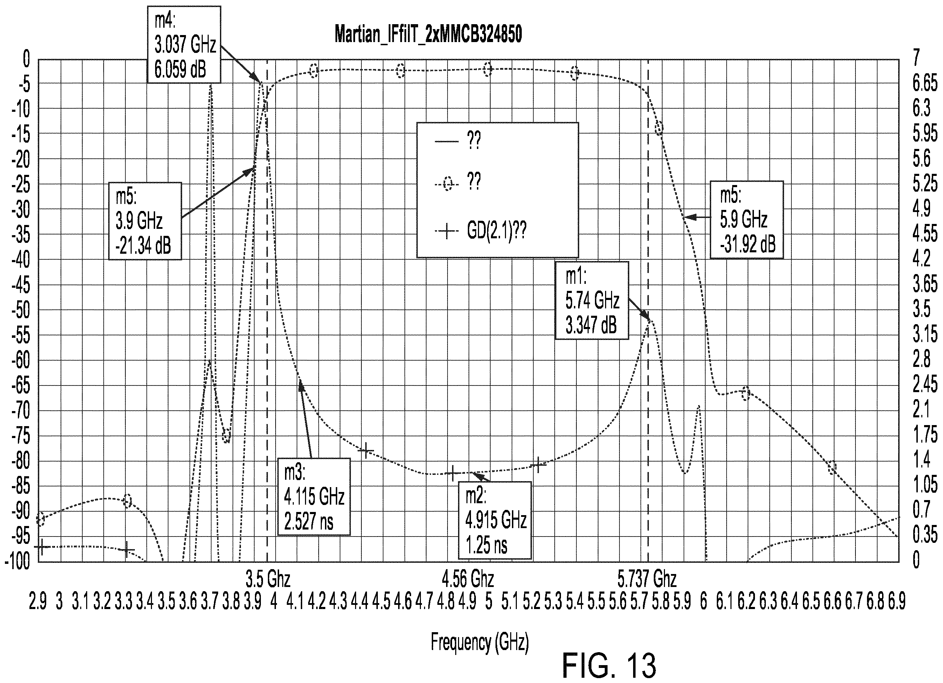

Various example simulations have been performed to illustrate results of one or more of the procedures according to various example embodiments. An example testing configuration is shown in FIG. 2 and used for one or more of the various simulations illustrated in FIGS. 13-16. The example test setup/configuration in FIG. 2 may provide for estimation, the OTA characterization of the entire transmission path, and the transmission path impulse response estimation and compensation. When the inverse transmission path impulse response loaded into transmission FIR in FIG. 2, the transmission path may become flat and may not contribute to the DPD observation path response.

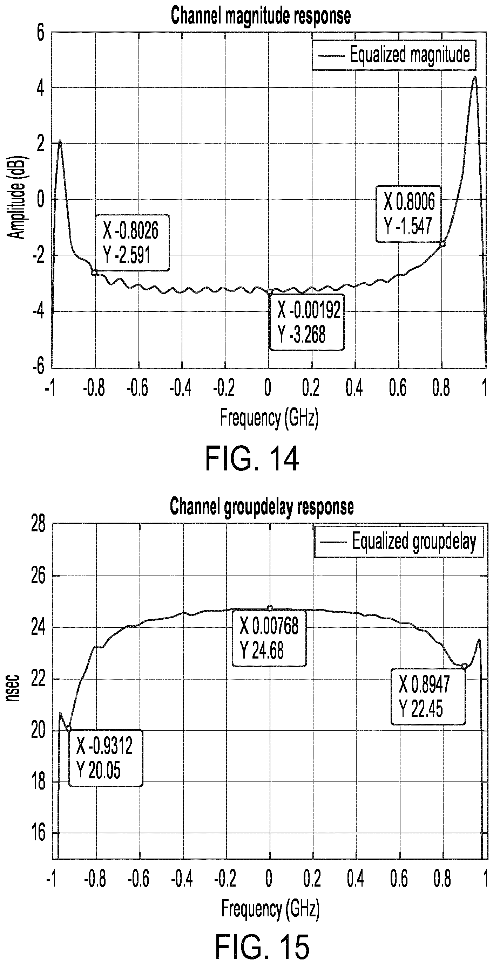

FIG. 13 illustrates an example of simulation results for applying one or more procedures/algorithms according to various example embodiments. For example, FIG. 13 illustrates an mmWave IF filter response that may limit a characterization bandwidth of the observation path to 1600 MHz. FIG. 10 illustrates another example of simulation results for applying one or more procedures/algorithms according to various example embodiments. For example, FIG. 14 illustrates a group delay of an mmWave IF filter. FIG. 15 illustrates another example of simulation results for applying one or more procedures/algorithms according to various example embodiments. For example, FIG. 15 illustrates a magnitude response of an mmWave IF filter with a bandwidth of 1600 MHz.

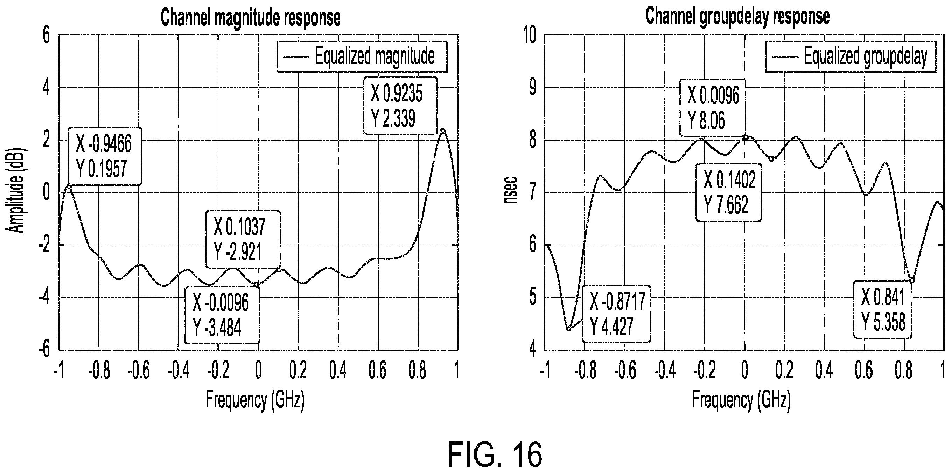

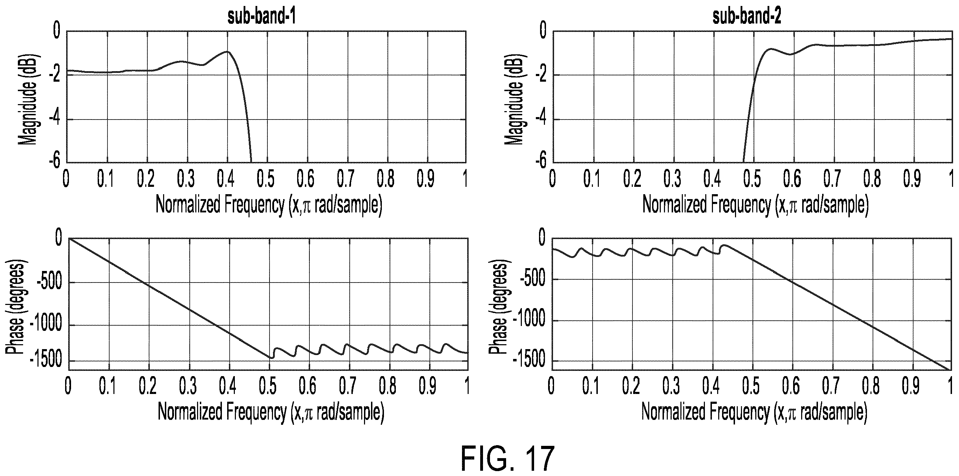

FIG. 16 illustrates a further example of simulation results for applying one or more procedures/algorithms according to various example embodiments. For example, FIG. 16 illustrates an estimated response (inverse) with 16 weights/coefficients at a bandwidth of 1600 MHz. FIG. 17 illustrates another example of simulation results for applying one or more procedures/algorithms according to various example embodiments. For example, FIG. 17 illustrates a DPD observation path 108 response for subbands Low(1) and High(2), with 16 weights/coefficients and a bandwidth of 1600MHz.

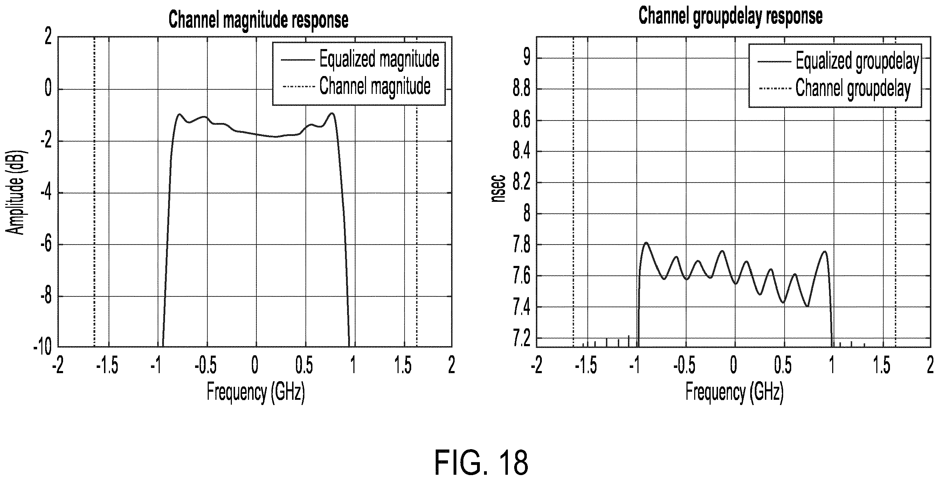

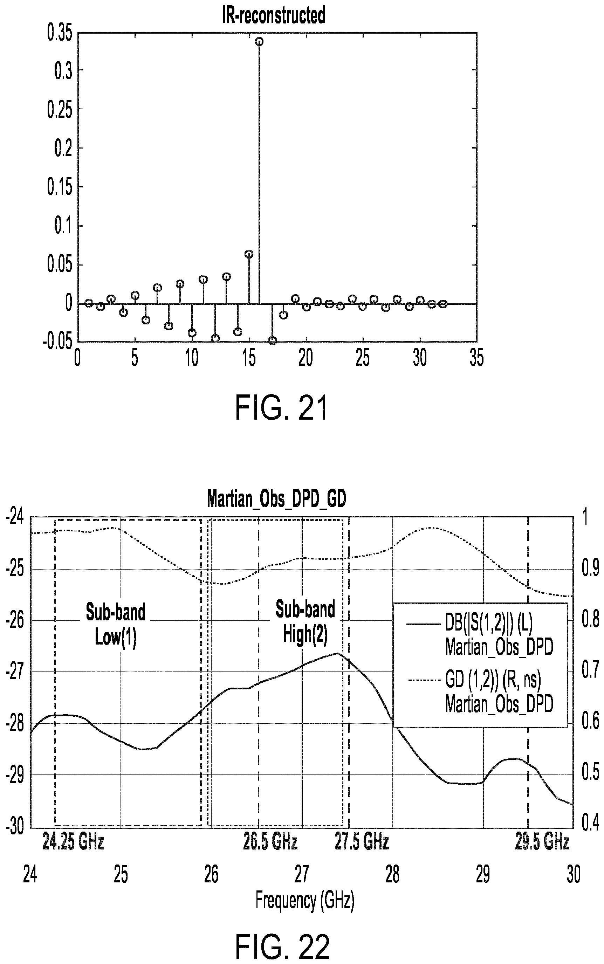

FIGS. 18-22 illustrate various simulations for a DPD observation path 108 according to certain example embodiments. FIG. 22 illustrates a transmission source fed to the DPD observation path 108 with a response using an inverse impulse response of transmission path loaded into the transmission FIR, according to various example embodiments. The analog subbands Low(1) and High(2) may be captured for further processing. The resulting estimated DPD observation responses may be shown in FIGS. 18-21.

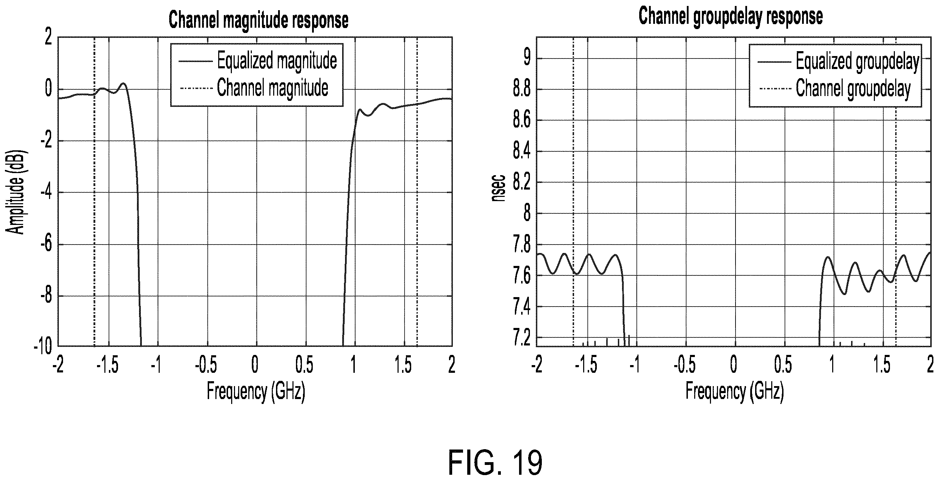

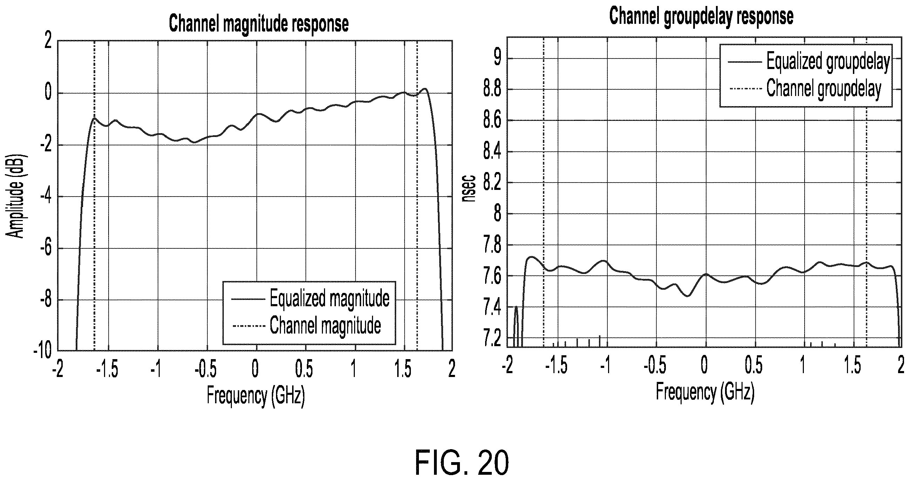

FIG. 18 illustrates an example of simulation results for applying one or more procedures/algorithms according to various example embodiments. For example, FIG. 18 illustrates a response for subband Low(1) with magnitude and group delay at a bandwidth of 1600 MHz. FIG. 19 illustrates an example of simulation results for applying one or more procedures/algorithms according to various example embodiments. For example, FIG. 19 illustrates a response for subband High(2) with magnitude and group delay at a bandwidth of 1600 MHz. FIG. 20 illustrates an example of simulation results for applying one or more procedures/algorithms according to various example embodiments. For example, FIG. 20 illustrates an aggregated response for the DPD observation path 108, which may be a combination of Low(1) and High(2) with 32 weights/coefficients at a bandwidth of 3200MHz. FIG. 21 illustrates an example of simulation results for applying one or more procedures/algorithms according to various example embodiments. For example, FIG. 21 illustrates an aggregated impulse response with 32 weights/coefficients at a bandwidth of 3200 MHz. The overall aggregate response shown in FIG. 21 has the impulse response shown in FIG. 22 showing a good wideband estimation of DPD observation path 108 with a bandwidth of 3200 MHz.

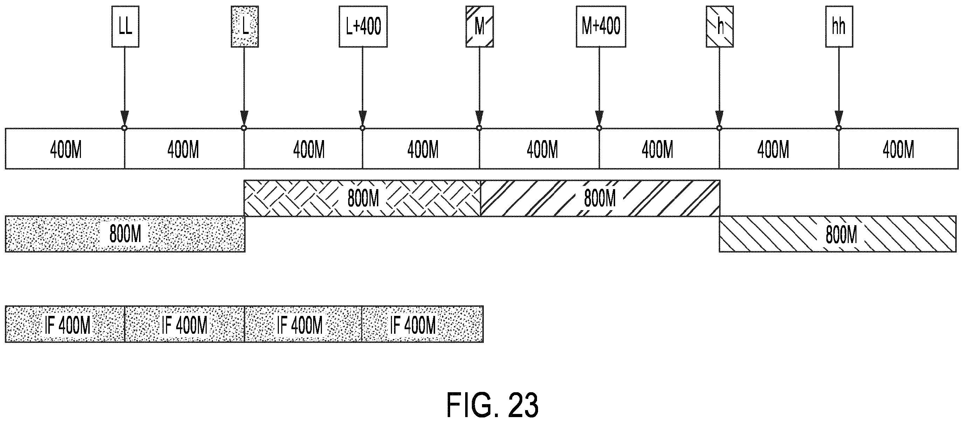

FIG. 23 illustrates an example diagram of a Martian radio with a subband of 800 MHz, according to various example embodiments. The mmWave radio may have multiple 800 MHz subband observations used to reconstruct the single 3200 MHz band.

According to various example embodiments, in 5G technology, large bandwidth (e.g., bandwidth > 3200 MHz) characterization/equalization of transmission path and DPD path may provide for proper operation of mmWave radio in 5G. In 6G and other technology, certain example embodiments may provide a solution for very large bandwidth operation, characterization, and equalization of the transmission path and the DPD observation path 108.

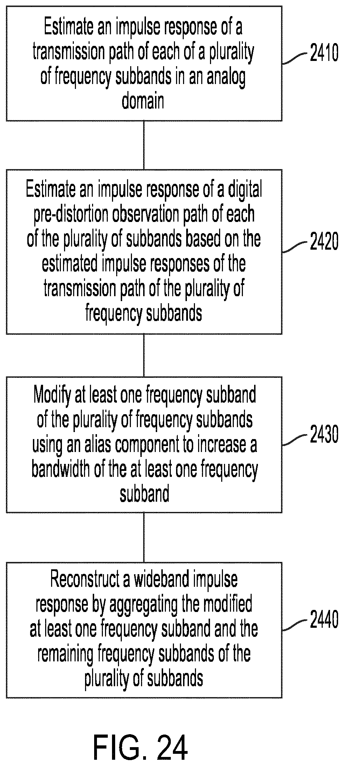

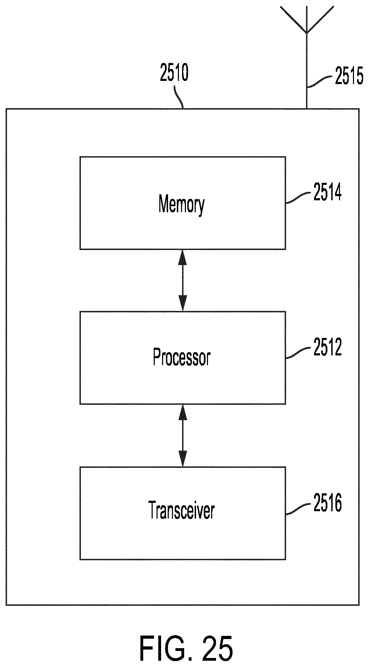

FIG. 24 illustrates an example flow diagram of a method, according to certain example embodiments. In an example embodiment, the method of FIG. 24 may be performed by a network element, or a group of multiple network elements in a 3GPP system, such as LTE or 5G-NR. For instance, in an example embodiment, the method of FIG. 24 may be performed by a network or network entity, such as a base station or gNB, similar to apparatus 25102510 illustrated in FIG. 25.

According to various example embodiments, the method of FIG. 24 may include, at 2410, estimating an impulse response of a transmission path of each of a plurality of frequency subbands in an analog domain. At 2420, the method may include estimating an impulse response of a digital pre-distortion observation path of each of the plurality of subbands based on the estimated impulse responses of the transmission path of the plurality of frequency subbands.

At 2430, the method may include modifying at least one frequency subband of the plurality of frequency subbands using an alias component to increase a bandwidth of the at least one frequency subband. At 2440, the method may include reconstructing a wideband impulse response by aggregating the modified at least one frequency subband and the remaining frequency subbands of the plurality of subbands.

FIG. 25 illustrates an apparatus 2510 according to various example embodiments. In the various example embodiments, the apparatus 2510 may be a network, network entity, element of the core network, or element in a communications network or associated with such a network, such as a base station, an NE, or a gNB. However, in other example embodiments, apparatus 2510 may include components or features not shown in FIG. 25.

According to various example embodiments, the apparatus 2510 may include at least one processor, and at least one memory, as shown in FIG. 25. The memory may store instructions that, when executed by the processor, cause the apparatus 2510 to estimate an impulse response of a transmission path of each of a plurality of frequency subbands in an analog domain and estimate an impulse response of a digital pre-distortion observation path of each of the plurality of subbands based on the estimated impulse responses of the transmission path of the plurality of frequency subbands. The apparatus 2510 may be further caused to modify at least one frequency subband of the plurality of frequency subbands using an alias component to increase a bandwidth of the at least one frequency subband and reconstruct a wideband impulse response by aggregating the modified at least one frequency subband and the remaining frequency subbands of the plurality of subbands.

Various example embodiments described above may provide several technical improvements, enhancements, and/or advantages. For instance, some example embodiments may provide advantages of one or more procedures to enable increasing accuracy of characterization of the DPD observation path, including to achieve a level of accuracy necessary to satisfy EESS requirements for the mmWave 24-GHz band. A wide bandwidth equalization for the transmission path and DPD observation paths may be needed in 6G products to give but one example.

Certain example embodiments may also provide for subband analysis to be performed in analog domain and synthesis of the aggregate band in the digital domain. Some example embodiments may allow for reconstruction of aggregate impulse responses due to limited accuracy at subband edge by implementing an alias component. Using RFSW, the one or more procedures may be flexibly applied due to using single shot full band characterization using RFSW. Further, some example embodiments may provide real time tracking of temperature variation when implemented in the ASIC.

In some example embodiments, apparatus 2510 may include one or more processors, one or more computer-readable storage medium (for example, memory, storage, or the like), one or more radio access components (for example, a modem, a transceiver, or the like), and/or a user interface. In some example embodiments, apparatus 2510 may be configured to operate using one or more radio access technologies, such as GSM, LTE, LTE-A, NR, 5G, WLAN, WiFi, NB-IoT, Bluetooth, NFC, MulteFire, and/or any other radio access technologies.

As illustrated in the example of FIG. 25, apparatus 2510 may include or be coupled to processor 2512 for processing information and executing instructions or operations. Processor 2512 may be any type of general or specific purpose processor. In fact, processor 2512 may include one or more of general-purpose computers, special purpose computers, microprocessors, DSPs, field-programmable gate arrays (FPGAs), ASICs, and processors based on a multi-core processor architecture, as examples. While a single processor 2512 for apparatus 2510 is shown in FIG. 25, multiple processors may be utilized according to other example embodiments. For example, it should be understood that, in certain example embodiments, apparatus 2510 may include two or more processors that may form a multiprocessor system (for example, in this case processor 2512 may represent a multiprocessor) that may support multiprocessing. According to certain example embodiments, the multiprocessor system may be tightly coupled or loosely coupled to, for example, form a computer cluster).

Processor 2512 may perform functions associated with the operation of apparatus 2510 including, as some examples, precoding of antenna gain/phase parameters, encoding and decoding of individual bits forming a communication message, formatting of information, and overall control of the apparatus 2510, including processes illustrated in FIGS. 1A-2, 11, 12, and 24.

Apparatus 2510 may further include or be coupled to memory 2514 (internal or external), which may be coupled to processor 2512, for storing information and instructions that may be executed by processor 2512. Memory 2514 may be one or more memories and of any type suitable to the local application environment, and may be implemented using any suitable volatile or nonvolatile data storage technology such as a semiconductor-based memory device, a magnetic memory device and system, an optical memory device and system, fixed memory, and/or removable memory. For example, memory 2514 can include any combination of random access memory (RAM), read only memory (ROM), static storage such as a magnetic or optical disk, hard disk drive (HDD), or any other type of non-transitory machine or computer readable media. The instructions stored in memory 2514 may include program instructions or computer program code that, when executed by processor 2512, enable the apparatus 2510 to perform tasks as described herein.

In certain example embodiments, apparatus 2510 may further include or be coupled to (internal or external) a drive or port that is configured to accept and read an external computer readable storage medium, such as an optical disc, universal serial bus (USB) drive, flash drive, or any other storage medium. For example, the external computer readable storage medium may store a computer program or software for execution by processor 2512 and/or apparatus 2510 to perform any of the methods illustrated in FIGS. 1A-2, 11, 12, and 24.

In some example embodiments, apparatus 2510 may also include or be coupled to one or more antennas 2515 for receiving a downlink signal and for transmitting via an uplink from apparatus 2510. Apparatus 2510 may further include a transceiver 2516 configured to transmit and receive information. The transceiver 2516 may also include a radio interface that may correspond to a plurality of radio access technologies including one or more of GSM, LTE, LTE-A, 5G, NR, WLAN, NB-IoT, Bluetooth, BT-LE, NFC, RFID, UWB, or the like. The radio interface may include other components, such as filters, converters (for example, digital-to-analog converters or the like), symbol demappers, signal shaping components, an Inverse Fast Fourier Transform (IFFT) module, or the like, to process symbols, such as orthogonal frequency division multiple access (OFDMA) symbols, carried by a downlink or an uplink.

For instance, transceiver 2516 may be respectively configured to modulate information on to a carrier waveform for transmission and demodulate received information for further processing by other elements of apparatus 2510. In other example embodiments, transceiver 2516 may be capable of transmitting and receiving signals or data directly. Additionally or alternatively, in some example embodiments, apparatus 2510 may include an input and/or output device (I/O device). In certain example embodiments, apparatus 2510 may further include a user interface, such as a graphical user interface or touchscreen.

In certain example embodiments, memory 2514 stores software modules that provide functionality when executed by processor 2512. The modules may include, for example, an operating system that provides operating system functionality for apparatus 2510. The memory 2514 may also store one or more functional modules, such as an application or program, to provide additional functionality for apparatus 2510. The components of apparatus 2510 may be implemented in hardware, or as any suitable combination of hardware and software. According to certain example embodiments, apparatus 2510 may optionally be configured to communicate with one or more wired or wireless communications links, according to any radio access technology, such as NR.

According to certain example embodiments, processor 2512 and memory 2514 may be included in or may form a part of processing circuitry or control circuitry. In addition, in some example embodiments, transceiver 2516 may be included in or may form a part of transceiving circuitry.

In some example embodiments, an apparatus (e.g., apparatus 2510) may include means for performing a method, a process, or any of the variants discussed herein. Examples of the means may include one or more processors, memory, controllers, transmitters, receivers, and/or computer program code for causing the performance of the operations.

Certain example embodiments may be directed to an apparatus that includes means for performing any of the methods described herein including, for example, means for estimating an impulse response of a transmission path of each of a plurality of frequency subbands in an analog domain and means for estimating an impulse response of a digital pre-distortion observation path of each of the plurality of subbands based on the estimated impulse responses of the transmission path of the plurality of frequency subbands. The apparatus may also include means for modifying at least one frequency subband of the plurality of frequency subbands using an alias component to increase a bandwidth of the at least one frequency subband and means for reconstructing a wideband impulse response by aggregating the modified at least one frequency subband and the remaining frequency subbands of the plurality of subbands.

As used herein, the term "circuitry" may refer to hardware-only circuitry implementations (for example, analog and/or digital circuitry), combinations of hardware circuits and software, combinations of analog and/or digital hardware circuits with software/firmware, any portions of hardware processor(s) with software, including digital signal processors, that work together to cause an apparatus (for example, apparatus 2510) to perform various functions, and/or hardware circuit(s) and/or processor(s), or portions thereof, that use software for operation but where the software may not be present when it is not needed for operation. As a further example, as used herein, the term "circuitry" may also cover an implementation of merely a hardware circuit or processor or multiple processors, or portion of a hardware circuit or processor, and the accompanying software and/or firmware. The term circuitry may also cover, for example, a baseband integrated circuit in a server, cellular network node or device, or other computing or network device.

A computer program product may include one or more computer-executable components which, when the program is run, are configured to carry out some example embodiments. The one or more computer-executable components may be at least one software code or portions of it. Modifications and configurations required for implementing functionality of certain example embodiments may be performed as routine(s), which may be implemented as added or updated software routine(s). Software routine(s) may be downloaded into the apparatus.

As an example, software or a computer program code or portions of it may be in a source code form, object code form, or in some intermediate form, and it may be stored in some sort of carrier, distribution medium, or computer readable medium, which may be any entity or device capable of carrying the program. Such carriers may include a record medium, computer memory, read-only memory, photoelectrical and/or electrical carrier signal, telecommunications signal, and software distribution package, for example. Depending on the processing power needed, the computer program may be executed in a single electronic digital computer or it may be distributed amongst a number of computers. The computer readable medium or computer readable storage medium may be a non-transitory medium.

In other example embodiments, the functionality may be performed by hardware or circuitry included in an apparatus (for example, apparatus 2510), for example through the use of an ASIC, a programmable gate array (PGA), a field programmable gate array (FPGA), or any other combination of hardware and software. In yet another example embodiment, the functionality may be implemented as a signal, a non-tangible means that can be carried by an electromagnetic signal downloaded from the Internet or other network.

According to certain example embodiments, an apparatus, such as a node, device, or a corresponding component, may be configured as circuitry, a computer, or a microprocessor, such as single-chip computer element, or as a chipset, including at least a memory for providing storage capacity used for arithmetic operation and an operation processor for executing the arithmetic operation.

The features, structures, or characteristics of example embodiments described throughout this specification may be combined in any suitable manner in one or more example embodiments. For example, the usage of the phrases "certain embodiments," "an example embodiment," "some embodiments," or other similar language, throughout this specification refers to the fact that a particular feature, structure, or characteristic described in connection with an embodiment may be included in at least one embodiment. Thus, appearances of the phrases "in certain embodiments," "an example embodiment," "in some embodiments," "in other embodiments," or other similar language, throughout this specification do not necessarily refer to the same group of embodiments, and the described features, structures, or characteristics may be combined in any suitable manner in one or more example embodiments. Further, the terms "cell", "node", "gNB", or other similar language throughout this specification may be used interchangeably.

As used herein, "at least one of the following: <a list of two or more elements>" and "at least one of <a list of two or more elements>" and similar wording, where the list of two or more elements are joined by "and" or "or," mean at least any one of the elements, or at least any two or more of the elements, or at least all the elements.

One having ordinary skill in the art will readily understand that the disclosure as discussed above may be practiced with procedures in a different order, and/or with hardware elements in configurations which are different than those which are disclosed. Therefore, although the disclosure has been described based upon these example embodiments, it would be apparent to those of skill in the art that certain modifications, variations, and alternative constructions would be apparent, while remaining within the spirit and scope of example embodiments. Although the above embodiments refer to 5G NR and LTE technology, the above embodiments may also apply to any other present or future 3GPP technology, such as LTE-advanced, and/or fourth generation (4G) technology.

**Claims**

1. An apparatus comprising:

   at least one processor; and
   at least one memory storing instructions that, when executed by the at least one processor, cause the apparatus at least to:

   estimate an impulse response of a transmission path of each of a plurality of frequency subbands in an analog domain,
   estimate an impulse response of a digital pre-distortion observation path of each of the plurality of subbands based on the estimated impulse responses of the transmission path of the plurality of frequency subbands,
   modify at least one frequency subband of the plurality of frequency subbands using an alias component to increase a bandwidth of the at least one frequency subband, and
   reconstruct a wideband impulse response by aggregating the modified at least one frequency subband and the remaining frequency subbands of the plurality of subbands.

2. The apparatus according to claim 1, wherein the apparatus is further caused to:
   apply an inverse of a frequency response to the estimated impulse response of the transmission path for each of the plurality of frequency subbands.

3. The apparatus according to one of claim 1 or claim 2, wherein the alias component is based on at least:

> a number of impulse response coefficients;
> a sampling frequency; and
> information about one or more edges of a frequency band formed of the plurality of subbands.

4. The apparatus according to claim 3, wherein the modifying the at least one frequency subband using the alias component comprises applying a weighted modifier to each of the impulse response coefficients.

5. The apparatus according to any one of claims 1-4, wherein the plurality of frequency subbands are received over the air,
   wherein the apparatus is further caused to: generate a transfer function for each of the plurality of frequency subbands, and wherein each of the plurality of subbands is filtered using at least one of a low pass filter or a high pass filter.

6. A method comprising:

> estimating an impulse response of a transmission path of each of a plurality of frequency subbands in an analog domain;
> estimating an impulse response of a digital pre-distortion observation path of each of the plurality of subbands based on the estimated impulse responses of the transmission path of the plurality of frequency subbands;
> modifying at least one frequency subband of the plurality of frequency subbands using an alias component to increase a bandwidth of the at least one frequency subband; and
> reconstructing a wideband impulse response by aggregating the modified at least one frequency subband and the remaining frequency subbands of the plurality of subbands.

7. The method according to claim 6, further comprising applying an inverse of a frequency response to the estimated impulse response of the transmission path for each of the plurality of frequency subbands.

8. The method according to one of claim 6 or claim 7, wherein the alias component is based on at least:

> a number of impulse response coefficients;
> a sampling frequency; and
> information about one or more edges of a frequency band formed of the plurality of subbands.

9. The method according to claim 8, wherein the modifying the at least one frequency subband using the alias component comprises applying a weighted modifier to each of the impulse response coefficients.

10. The method according to any one of claims 6-9, wherein the plurality of frequency subbands are received over the air, further comprising:

> generating a transfer function for each of the plurality of frequency subbands, and
> wherein each of the plurality of subbands is filtered using at least one of a low pass filter or a high pass filter.

11. An apparatus comprising:

> means for estimating an impulse response of a transmission path of each of a plurality of frequency subbands in an analog domain;
> means for estimating an impulse response of a digital pre-distortion observation path of each of the plurality of subbands based on the estimated impulse responses of the transmission path of the plurality of frequency subbands;
> means for modifying at least one frequency subband of the plurality of frequency subbands using an alias component to increase a bandwidth of the at least one frequency subband; and
> means for reconstructing a wideband impulse response by aggregating the modified at least one frequency subband and the remaining frequency subbands of the plurality of subbands.

12. The apparatus according to claim 11, further comprising means for applying an inverse of a frequency response to the estimated impulse response of the transmission path for each of the plurality of frequency subbands.

13. The method according to one of claim 11 or claim 12, wherein the alias component is based on at least:

   a number of impulse response coefficients;
   a sampling frequency; and
   information about one or more edges of a frequency band formed of the plurality of subbands.

14. The apparatus according to claim 13, wherein the modifying the at least one frequency subband using the alias component comprises means for applying a weighted modifier to each of the impulse response coefficients.

15. The apparatus according to any one of claims 11-14, wherein the plurality of frequency subbands are received over the air, and further comprising:
   generating a transfer function for each of the plurality of frequency subbands.

FIG. 1A

EP 4 459 934 A1

FIG. 1B

FIG. 2

FIG. 3

FIG. 4

FIG. 5A

FIG. 5B

EP 4 459 934 A1

FIG. 6A

FIG. 6B

EP 4 459 934 A1

EP 4 459 934 A1

Channel magnitude response

FIG. 7A

Channel groupdelay response

FIG. 7B

FIG. 8

**FIG. 9**

**FIG. 10**

Start n=1

1110 — Tx IF= 4.9152GHz
BW=IF ± 800MHz

1120 — RF Band
?
Low        High → To FIG.11B

1130 — Low-band(24.25-27.5)
LO=10.375GHz

1131 — Tx Path Subband_Low#n
Characterization

Obs. Path DPD
Subband_Low#n
1600MHz
FIR weights#16

1132 — Estimate Tx Path Subband_
Low#n Tx-Inverse->Tx path

1133 — Estimate Obs. DPD Subband_
Low#n 1600MHz

1134

1135 — n=k
?
NO     Yes

1136 — Reconstruct Algorithm Entire
Obs. DPD (3200MHz) Band with
Low1 & Low2 FIR Coefficients

Obs. Path DPD
band_Low
3200MHz
FIR weights#32

1137

FIG. 11A

From FIG.11A

1140 — High-band(26.5-29.5)
LO=11.5GHz

1141 — Tx Path Subband_High#n
Characterization

Obs. Path DPD
Subband_High#n 1142 — Estimate Tx Path Subband_
1600MHz High#n Tx-Inverse->Tx path
FIR weights#16

1143 — Estimate Obs. DPD Subband_
1144 ← High#n 1600MHz

1145 — n=k
NO ?
Yes

1146 — Reconstruct Algorithm Entire
Obs. DPD (3200MHz) Band with
*High#1* & *High#2* FIR Coefficients

Obs. Path DPD
band_*High*
3200MHz 1147
FIR weights#32

## FIG. 11B

FIG. 12

FIG. 13

Martian_IFfilT_2xMMCB324850

m4:
3.037 GHz
6.059 dB

m5:
3.9 GHz
-21.34 dB

m5:
5.9 GHz
-31.92 dB

m1:
5.74 GHz
3.347 dB

m3:
4.115 GHz
2.527 ns

m2:
4.915 GHz
1.25 ns

—— ??

-○- ??

—+— GD(2.1)??

3.5 Ghz          4.56 Ghz          5.737 Ghz

2.9 3 3.1 3.2 3.3 3.4 3.5 3.6 3.7 3.8 3.9 4 4.1 4.2 4.3 4.4 4.5 4.6 4.7 4.8 4.9 5 5.1 5.2 5.3 5.4 5.5 5.6 5.7 5.8 5.9 6 6.1 6.2 6.3 6.4 6.5 6.6 6.7 6.8 6.9

Frequency (GHz)

EP 4 459 934 A1

**Channel magnitude response**

FIG. 14

**Channel groupdelay response**

FIG. 15

Channel groupdelay response
— Equalized groupdelay

X 0.0096
Y 8.06

X 0.1402
Y 7.662

X -0.8717
Y 4.427

X 0.841
Y 5.358

nsec

Frequency (GHz)

Channel magnitude response
— Equalized magnitude

X 0.9235
Y 2.339

X 0.1037
Y -2.921

X -0.0096
Y -3.484

X -0.9466
Y 0.1957

Amplitude (dB)

Frequency (GHz)

FIG. 16

**FIG. 17**

EP 4 459 934 A1

FIG. 18

FIG. 19

Channel magnitude response

Channel groupdelay response

FIG. 20

EP 4 459 934 A1

## IR-reconstructed

FIG. 21

## Martian_Obs_DPD_GD

Sub-band Low(1)

Sub-band High(2)

DB(|S(1,2)|) (L) Martian_Obs_DPD

GD (1,2)) (R, ns) Martian_Obs_DPD

24.25 GHz    26.5 GHz    27.5 GHz    29.5 GHz

Frequency (GHz)

FIG. 22

FIG. 23

Estimate an impulse response of a transmission path of each of a plurality of frequency subbands in an analog domain — 2410

Estimate an impulse response of a digital pre-distortion observation path of each of the plurality of subbands based on the estimated impulse responses of the transmission path of the plurality of frequency subbands — 2420

Modify at least one frequency subband of the plurality of frequency subbands using an alias component to increase a bandwidth of the at least one frequency subband — 2430

Reconstruct a wideband impulse response by aggregating the modified at least one frequency subband and the remaining frequency subbands of the plurality of subbands — 2440

FIG. 24

FIG. 25

Europäisches
Patentamt
European
Patent Office
Office européen
des brevets

# EUROPEAN SEARCH REPORT

Application Number

EP 24 16 9649

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2016/065147 A1 (PRATT PATRICK JOSEPH [IE] ET AL) 3 March 2016 (2016-03-03) * paragraphs [0047], [0086], [0088] * * figures 1, 11, 12A * | 1-15 | INV. H04L25/02 H04B1/04 H03F1/32 |
| A | US 2011/317786 A1 (MUJICA FERNANDO A [US] ET AL) 29 December 2011 (2011-12-29) * paragraphs [0028] - [0030] * * figure 2 * | 1-15 | |
| A | US 10 305 435 B1 (MURUGESU ROSANAH [US] ET AL) 28 May 2019 (2019-05-28) * the whole document * | 1-15 | |

TECHNICAL FIELDS
SEARCHED       (IPC)

H04L
H04B
H03F

The present search report has been drawn up for all claims

| Place of search | Date of completion of the search | Examiner |
|---|---|---|
| Munich | 23 September 2024 | Franz, Stefan |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 24 16 9649

This annex lists the patent family members relating to the patent documents cited in the above-mentioned European search report.
The members are as contained in the European Patent Office EDP file on
The European Patent Office is in no way liable for these particulars which are merely given for the purpose of information.

23-09-2024

| Patent document cited in search report | | Publication date | Patent family member(s) | | Publication date |
|---|---|---|---|---|---|
| US 2016065147 | A1 | 03-03-2016 | CN 105391459 A | | 09-03-2016 |
| | | | EP 2991221 A1 | | 02-03-2016 |
| | | | US 2016065147 A1 | | 03-03-2016 |
| US 2011317786 | A1 | 29-12-2011 | NONE | | |
| US 10305435 | B1 | 28-05-2019 | NONE | | |

EPO FORM P0459

For more details about this annex : see Official Journal of the European Patent Office, No. 12/82